# EUROPEAN PATENT APPLICATION

(11) **EP 2 648 210 A1**
(43) Date of publication of application: **09.10.2013**
(21) Application number: 11845593.0
(22) Date of filing: 30.11.2011
(51) Int. Cl.: H01L 21/02, H01L 21/20, H01L 21/205, H01L 27/12

(54) **COMPOSITE SUBSTRATE AND PRODUCTION METHOD**

(30) Priority: 30.11.2010 JP 2010266111; 30.11.2010 JP 2010266112
(71) Applicant: Kyocera Corporation, Kyoto-shi Kyoto 612-8501 (JP)
(72) Inventor: KITADA, Masanobu, Soraku-gun Kyoto 619-0237 (JP); OGAWA, Motokazu, Soraku-gun Kyoto 619-0237 (JP)
(74) Representative: Beetz & Partner
(86) International application number: PCT/JP2011/077677
(87) International publication number: WO 2012/074009

(57) **Abstract**

A composite substrate which includes a silicon layer having less lattice defects is provided. A composite substrate (40) includes an insulating substrate (30) and a functional layer (21) of which one main surface is bonded to an upper surface of the substrate (30). A dopant concentration of the functional layer (21) decreases from the other main surface toward the substrate (30) side in a thickness direction of the functional layer.

## Description

### Technical Field

The present invention relates to a composite substrate including a silicon layer and a method of manufacturing the composite substrate.

### Background Art

Recently, technologies to decrease parasitic capacitance for improving the performance of a semiconductor device have advanced. Examples of a technology to decrease the parasitic capacitance include an SOS (Silicon On Sapphire) structure. For example, examples of a method which forms the SOS structure include a technology which is disclosed in Japanese Unexamined Patent Publication JP-A 10-12547(1998).

### Summary of Invention

However, in the technology disclosed in JP-A 10-12547(1998), because lattice structures of silicon and sapphire are different to each other, lattice defects occur in the silicon.

Thereby, a composite substrate which includes a silicon layer having less lattice defects is required.

A method of manufacturing a composite substrate according to an embodiment of the invention includes: a step of preparing a first substrate which is formed of a first silicon having a dopant; a step of forming a semiconductor layer by forming a second silicon on a main surface of the first substrate by an epitaxial growth; a step of bonding the semiconductor layer and a second substrate of insulation; and a step of selectively etching the semiconductor layer from the first substrate side up to a middle portion in a thickness direction of the semiconductor layer using an etchant, as the etchant being used whose etching rate with respect to silicon is decreased by a not less than a constant value in a dopant concentration of a threshold which is lower than a dopant concentration of the first substrate, and in the step of forming a semiconductor layer, the semiconductor layer being formed so as to include a first region in a thickness direction, which first region is in contact with the first substrate and in which the dopant concentration is decreased down to the threshold with increase in distance from the first substrate.

A composite substrate according to an embodiment of the invention includes: an insulating substrate and a semiconductor layer of which one main surface is bonded to an upper surface of the insulating substrate, a dopant concentration of the semiconductor layer being decreased from an other main surface of the semiconductor layer toward the one main surface of the semiconductor layer which is on a substrate side.

A composite substrate according to another embodiment of the invention includes: an insulating substrate and a semiconductor layer of which one main surface is bonded to an upper surface of the insulating substrate, a dopant concentration of the semiconductor layer being increased from a middle portion in a thickness direction of the semiconductor layer toward an other main surface of the semiconductor layer and from the middle portion in the thickness direction of the semiconductor layer toward the one main surface of the semiconductor layer which is on a substrate side.

According to the invention, a composite substrate which includes a silicon layer having less lattice defects can be provided.

### Brief Description of Drawings

Figs. 1(a) to 1(c) are cross-sectional views showing steps of a method of manufacturing a composite substrate according to an embodiment of the invention;
Figs. 2(a) to 2(c) are cross-sectional views showing manufacturing steps after the steps of Fig. 1;
Fig. 3(a) is a plan view showing a schematic configuration of a composite substrate according to an embodiment of the invention, and Fig. 3(b) is a perspective view showing the composite substrate a part of which is viewed in cross section;
Figs. 4(a) to 4(c) are cross-sectional views showing steps of a method of manufacturing a composite substrate according to an embodiment of the invention;
Figs. 5(a) to 5(c) are cross-sectional views showing manufacturing steps after the steps of Fig. 4;
Figs. 6(a) and 6(b) are cross-sectional views showing manufacturing steps after the steps of Fig. 5; and
Fig. 7(a) is a plan view showing a schematic configuration of a composite substrate according to an embodiment of the invention, and Fig. 7(b) is a perspective view showing the composite substrate a part of which is viewed in cross section.

### Description of Embodiments

An example of an embodiment of a method of manufacturing a composite substrate of the invention will be described with reference to drawings.

### (First Embodiment)

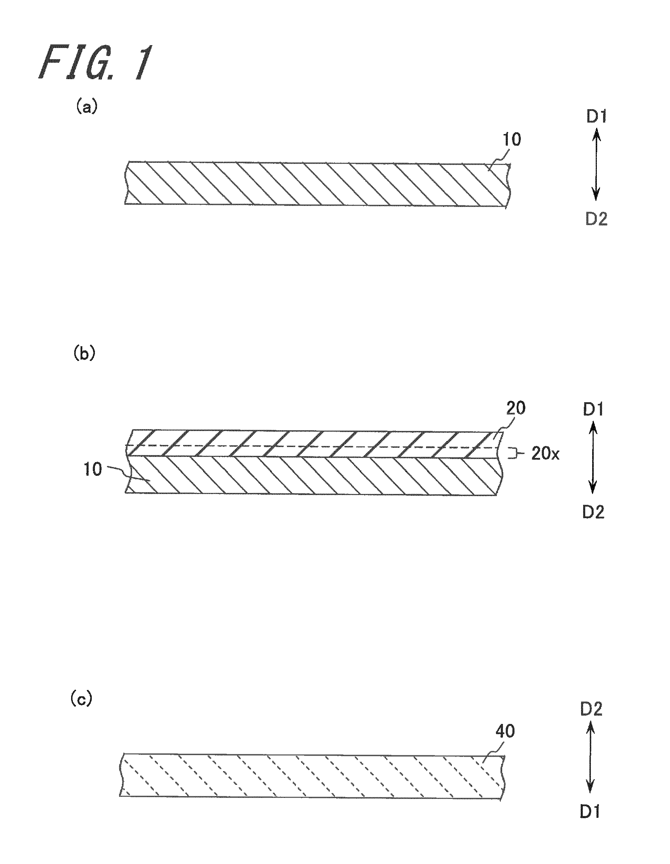

First, as shown in Fig. 1(a), a first substrate 10 which is formed of a first silicon (Si) including a dopant is prepared. As for the first silicon of the first substrate 10, p-type silicon or n-type silicon can be adopted. As for a dopant concentration of the first substrate 10, p⁺⁺ or n⁺⁺ dopant concentration having a relatively high concentration and p⁺ and n⁺ dopant concentration having a medium concentration can be adopted. The p⁺⁺ dopant concentration may be in a range of not less than 1 × 10¹⁸ [atoms/cm³] and not greater than 1 × 10²¹ [atoms/cm³]. The p⁺ dopant concentration may be in a range of not less than 1 × 10¹⁶ [atoms/cm³] and less than 1 × 10¹⁸ [atoms/cm³]. The n⁺⁺ dopant concentration may be in a range of not less than 5 × 10¹⁷ [atoms/cm³] and not greater than 1 × 10²¹ [atoms/cm³]. The n⁺ dopant concentration may be in a range of not less than 5 × 10¹⁵ [atoms/cm³] and less than 5 × 10¹⁷ [atoms/cm³]. In the present embodiment, the first substrate which is a p-type and in which the dopant concentration is p⁺⁺ is adopted. In addition, superscripts "++" and "+" of "p" and "n" are based on a resistance value of the silicon.

Subsequently, a second silicon is formed by an epitaxial growth on the upper surface in the arrow D1 direction side of the first substrate 10, and as shown in Fig. 1(b), a semiconductor layer 20 is formed. As for the method of the epitaxial growth, various methods can be adopted such as a thermal chemical vapor deposition (thermal CVD) in which gaseous silicon compound passes through the surface of the first substrate 10, is pyrolyzed, and is grown while the first substrate 10 is heated. Since the epitaxial growth is performed on the silicon substrate, compared to a case where the epitaxial growth is performed on a sapphire substrate, lattice defects of the semiconductor layer 20 can be decreased.

As for the semiconductor layer 20, a layer which is p-type or n-type silicon and in which the dopant is in a smaller concentration than in the first substrate 10 can be adopted. The semiconductor layer 20 is formed so that the dopant concentration is gradually decreased from the first substrate 10 side toward the upper surface side. A main surface of the semiconductor layer 20 of the side which does not contact the first substrate 10 is formed so as to have any one of p⁻ and n⁻ dopant concentration having relatively low concentration, and non-doped concentration. The p⁻ dopant concentration may be in a range of less than 1 × 10¹⁶ [atoms/cm³]. The n⁻ dopant concentration may be in a range of less than 5 × 10¹⁵ [atoms/cm³]. Here, the "non-doped silicon" means merely a silicon which is not intentionally doped with impurities, and is not limited to intrinsic silicon in which impurities are not included. The semiconductor layer 20 of the present embodiment adopts p-type silicon and is formed so that the dopant concentration of the upper surface portion is p⁻. In addition, a superscript "-" of "p" and "n" is based on a resistance value of the silicon. The dopant concentration of the semiconductor layer 20 is controlled by adjusting a supply amount of impurities when the epitaxial growth is performed. Non-doped silicon can be formed by making the supply of impurities be zero. Moreover, the dopant concentration may be gradually changed due to a diffusion decrease of the dopants which is generated when the epitaxial growth is performed.

In this way, the semiconductor layer 20 is configured, and thus, the semiconductor layer 20 has a distribution of a dopant concentration in the thickness direction. In other words, the semiconductor layer 20 is formed so as to have a first region 20x in at least the thickness direction which first region is in contact with the first substrate 10. The first region 20x is formed so that the dopant concentration is decreased down to a threshold described below with increase in distance from the first substrate 10. In the present embodiment, the decrease of the dopant concentration is also continued from the threshold with increase in distance from the first region 20x.

In the above-described step, in the semiconductor layer 20, the epitaxial growth may not be performed until the diffusion concentration of the dopant is saturated. In this case, the formed epitaxial layer is configured by only a transition region in which the dopant concentration is gradually changed from the first substrate 10 side. For example, by leaving the dopant concentration of the epitaxial layer to an extent which slightly exceeds a boundary of dopant concentration (threshold described below) in which the etching speed of an etchant is greatly changed, the thickness of the epitaxial layer can be smaller due to the etching.

Subsequently, as shown in Fig. 1(c), a second substrate 30 of insulation is prepared. As for materials of forming the second substrate 30, aluminum oxide single crystal (sapphire), silicon carbide, or the like may be used. In the present embodiment, sapphire is adopted as the second substrate 30.

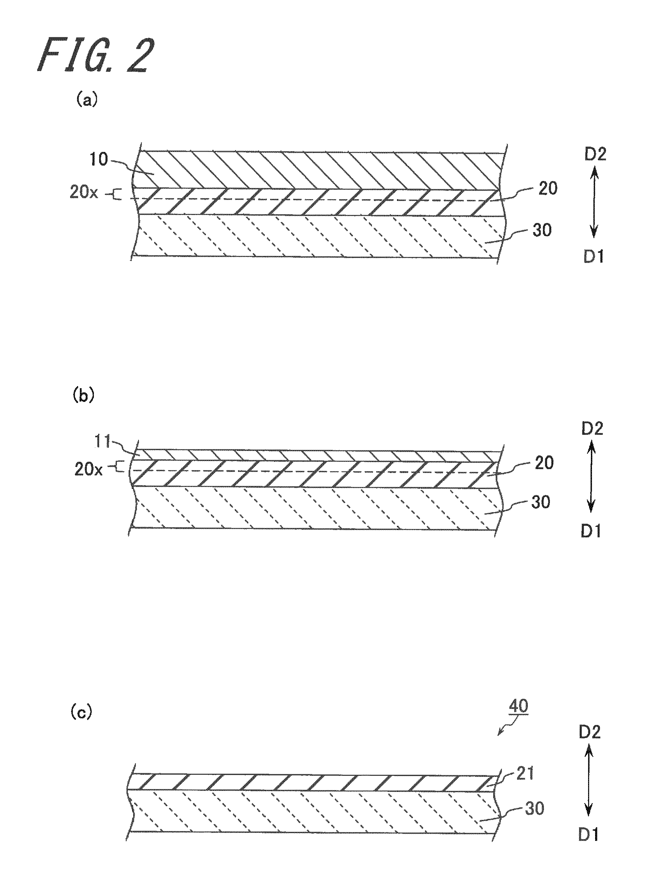

Subsequently, as shown in Fig. 2(a), the second substrate 30 and the main surface in the first direction side of the first semiconductor layer 20 are bonded to each other. Examples of the bonding method include a method which performs the bonding by activating the surfaces to be bonded and a method which performs the bonding using an electrostatic force. For example, examples of the method which activates the surface include a method which performs activation by radiating with ion beams in a vacuum and etching the surface, and a method which activates by etching the surface in a chemical solution. The bonding may be performed at a normal temperature.

In addition, at the time of the bonding, a method which does not use adhesive such as resin is adopted, and the semiconductor layer 20 and the second substrate 30 are directly bonded to each other by solid state bonding which uses interatomic force, or the like. At the time of the direct bonding, a combined layer may be formed between the semiconductor layer 20 and the second substrate 30. When the bonding is performed using the solid state bonding, it is preferable that surface roughness of the bonded surface of the semiconductor layer 20 and the second substrate 30 is small. For example, this surface roughness is represented by arithmetic average roughness Ra. A range of the surface roughness Ra may be less than 10 nm. By decreasing the average surface roughness Ra, the applied pressure when the semiconductor layer and the second substrate are bonded to each other can be decreased.

Through the steps up to here, an intermediate product, which includes the semiconductor layer 20 between the first substrate 10 and the second substrate 30, is produced.

Subsequently, as shown in Fig. 2(b), the thickness of the first substrate 10 is decreased by processing the intermediate product from the arrow D2 direction side. As for the processing method of decreasing the thickness, various methods such as abrasive grinding, chemical etching, or ion beam etching may be adopted, and a plurality of methods may be combined. Here, the first substrate in which the thickness is decreased becomes a first thin substrate 11.

In addition, as shown in Fig. 2(c), the thickness of the semiconductor layer 20 is decreased by performing etching using an etchant after the grinding. This etching can be performed by adopting a selective etchant (etching liquid) in which the etching speed is greatly changed due to difference of the dopant concentration. For example, examples of the selective etchant include a mixture of hydrofluoric acid, nitric acid and acetic acid, and a mixture of hydrofluoric acid, nitric acid and water. In the present embodiment, the mixture of hydrofluoric acid, nitric acid, and acetic acid is adopted as the etchant. In addition, in the etchant, an etching rate with respect to silicon is adjusted so as to be decreased by a not less than constant value in the dopant concentration of the threshold which is lower than the dopant concentration of the first substrate 10. Here, "the etching rate being decreased by a not less than constant value" indicates a case where an inflection point appears when a graph showing a relationship between the etching rate and the dopant concentration is prepared or a case where the etching rate is decreased by 1/10 or more in the threshold. In this example, in the present embodiment in which p-type silicon is adopted, the etchant is adjusted so that the etching speed is significantly decreased from a point of the threshold dopant concentration of 7 × 10¹⁷ to 2 × 10¹⁸ [atoms/cm³]. When a mixture ratio of hydrofluoric acid, nitric acid, and water is set to 1:3:8, the etching rate is set so as to be changed to 1/1000 or more from the point of the threshold. In addition, examples of other methods of performing the selective etching include an electric field etching method in a hydrogen fluoride solution of approximately 5%, and a pulse electrode anodizing method in a KOH solution. In the semiconductor layer 20, the first region 20x is etched. Here, the semiconductor layer in which the thickness is decreased by etching becomes a functional layer 21. For example, the thickness of the functional layer 21 may be in a range of several hundreds of nm to about 2 µm. In addition, when the first substrate 10 or the first thin substrate 11 remains, the remaining first substrate 10 or the first thin substrate 11 is also etched.

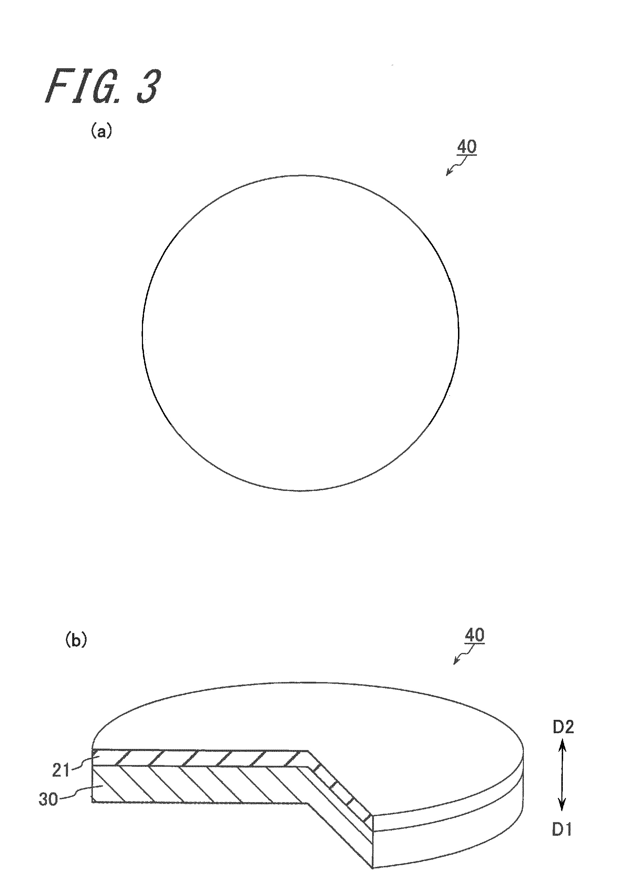

Through the steps up to here, as shown in Fig. 3, a composite substrate 40 can be manufactured in which the semiconductor layer 21 is laminated on the upper surface of the arrow D2 direction side of the insulating substrate 30. In other words, in the composite substrate 40, one main surface of the semiconductor layer 21 is bonded to the upper surface in the arrow D2 direction side of the substrate 30. In the dopant concentration of the semiconductor layer 21, the concentration of the bonded side (one main surface side; substrate 30 side) is lower than that of the other main surface side. In addition, when the dopant concentration is considered as magnitude of an electric resistance, the electric resistance of the semiconductor layer 21 is gradually decreased from the front side (the other main surface side) toward the bonded side (the one main surface side; substrate 30 side). In Fig. 3, the insulating substrate 30 indicates the second substrate 30 through the above-described manufacturing method, and the semiconductor layer 21 indicates the functional layer 21 in which the semiconductor layer 20 is thinned through the above-described manufacturing method.

In the above-described manufacturing method, gradient of the dopant concentration of the semiconductor layer 20 which becomes the functional layer 21 is formed on the surface of the side which is to be bonded to the second substrate 30 before being bonded to the second substrate 30. In this way, since the gradient is formed before the bonding, compared to a case where the gradient is formed after the bonding, unevenness of the thickness of the functional layer 21, which is formed on the upper surface of the second substrate 30, can be decreased. If the gradient is formed after the bonding, since the processing is performed from the first substrate 10 side, the functional layer is subjected to influence of unevenness of the thickness of the first substrate 10 or to influence of warping of the second substrate 30. A case where the functional layer in which the thickness is smaller than at least one of an unevenness amount of the thickness of the first substrate 10 and a warping amount of the second substrate 30 is formed is particularly effective. In addition, in general, it is said that there is the thickness unevenness of ± 10 [µm] in the silicon wafer. The thickness unevenness is significantly larger than the value of submicron from several tens of nm to several hundreds of nm, which is the thickness required in the silicon of an SOS substrate.

In the above-described steps, in the semiconductor layer 20 of the second substrate 30 side, the dopant concentration is significantly low, and the electric resistance is high. According to this configuration, when a semiconductor-device-function portion is formed on the functional layer 21 of the composite substrate 40, improved characteristics of having smaller parasitic capacitance or noise can be realized.

After the manufacturing of the composite substrate 40, the composite substrate 40 may be polished precisionally.. Uniformity of the thickness of the functional layer 21 can be improved due to the precision polishing. For example, examples of the etching means which is used in the fine etching include dry etching. Dry etching includes etching using a chemical reaction and etching using physical collision. Examples of etching using a chemical reaction include etching using reactive vapor (gas), etching using ions and ion beams, and etching using a radical. Examples of etching gas which is used for the reactive ion include sulfur hexafluoride (SF₆), and carbon tetrafluoride (CF₄). In addition, Examples of etching using physical collision include etching using ion beams. Examples of etching using ion beams include a method that uses a Gas Cluster Ion Beam (GCIB). It is possible to favorably perform the fine etching even with respect to a material substrate having a large area by scanning the substrate material 20X using a movable stage while etching the narrow region using the etching means.

In the above-described steps, the first substrate 10 is ground, and thus, the thickness is decreased. However, the grinding step may be omitted. When the grinding step is omitted, the first substrate 10 is removed by etching or the like.

In the above-described steps, a step in which the substrate is cleaned is not described. However, the substrate may be cleaned if necessary. Examples of a method of cleaning the substrate include various methods such as cleaning using ultrasonic waves, washing using an organic solvent, cleaning using chemicals, or cleaning using O₂ ashing. These cleaning methods may be adopted in combination.

In the above-described example, the case where the dopant concentration of the semiconductor layer 20 is continuously decreased with increase in distance from the first substrate 10 is described as an example. However, the invention is not limited to this example if it includes the first region 20x. For example, the dopant concentration of the region of the semiconductor layer 20 which is positioned on the side opposite to the first substrate 10 across the first region 20x may be equal to or more than the threshold, may be approximately equal to the threshold, and may be changed in stages in the thickness direction.

### (Second Embodiment)

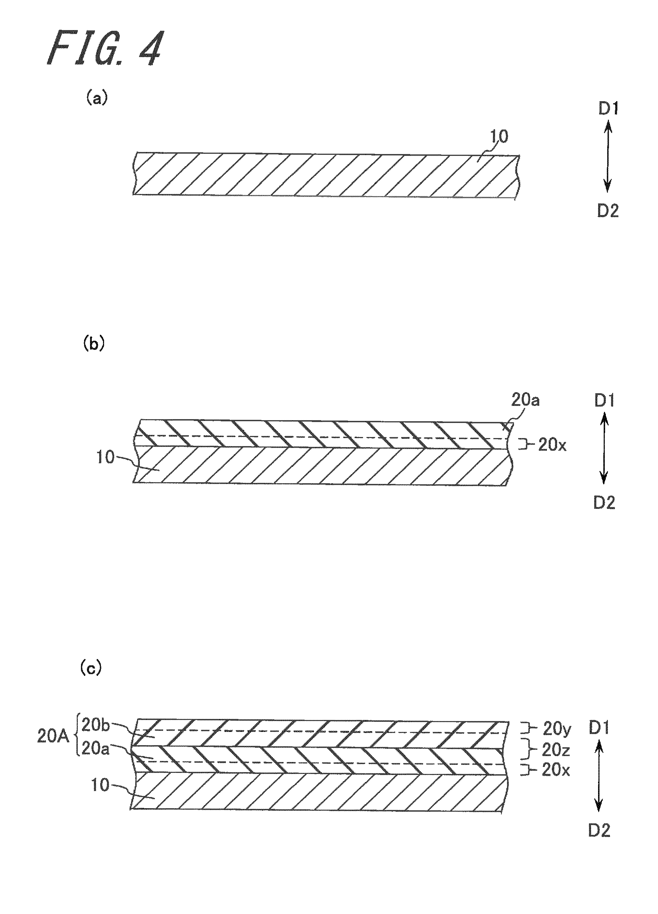

Figs. 4 to 6 are process drawings schematically showing a method of manufacturing a composite substrate of an example of a second embodiment of the invention. Additionally, in the present example, portions different from the example of the above-described first embodiment are described, and overlapped descriptions with respect to the similar elements or steps are omitted.

First, as shown in Fig. 4(a), similar to Fig. 1(a), the first substrate 10 which is formed of silicon (Si) is prepared.

Subsequently, silicon is formed by an epitaxial growth on the upper surface in the arrow D1 direction side of the first substrate 10, and thus, a semiconductor layer 20A is formed. The semiconductor layer 20A is formed by laminating a first semiconductor layer 20a and a second semiconductor layer 20b in the order from the first substrate 10 side. Specifically, first, as shown in Fig. 4(b), the first semiconductor layer 20a is formed.

As for the first semiconductor layer 20a, a layer which is p-type or n-type silicon and in which the dopant is smaller than in the first substrate 10 can be adopted. The first semiconductor layer 20a is formed so that the dopant concentration is gradually decreased from the first substrate 10 side toward the upper surface side. The upper surface portion (the surface on the side opposite to the surface which is in contact with the first substrate 10) of the first semiconductor layer 20 is formed so as to have any one of p⁻ and n⁻ dopant concentration having a relatively low concentration, and non-doped concentration. The p⁻ dopant concentration may be in a range less than 1 × 10¹⁶ [atoms/cm³]. The n⁻ dopant concentration may be in a range of less than 5 × 10¹⁶ [atoms/cm³]. The first semiconductor layer 20a of the present embodiment adopts p-type silicon and is formed so that the dopant concentration of the upper surface portion is p⁻. That is, the first semiconductor layer 20a includes the first region 20x in the portion which is in contact with the first substrate 10.

Subsequently, silicon is formed by an epitaxial growth on the upper surface in the arrow D1 direction side of the first semiconductor layer 20a, and as shown in Fig. 4(c), the second semiconductor layer 20b is formed. Since the epitaxial growth is performed on the silicon substrate in the second semiconductor layer 20b, compared to a case where the epitaxial growth is performed on a sapphire substrate, lattice defects can be decreased.

As for the second semiconductor layer 20b, a layer which is p-type or n-type silicon and in which the dopant is much compared to the first semiconductor layer 20a can be adopted. The second semiconductor layer 20b is formed so that the dopant concentration is gradually increased from the first semiconductor layer 20a side toward the upper surface side direction of the arrow D1 direction side. The upper surface portion of the second semiconductor layer 20 is formed so as to have any one dopant concentration of n⁺⁺, n⁺, p⁺, and p⁺⁺. The second semiconductor layer 20b of the present embodiment adopts p-type silicon and is formed so that the dopant concentration of the upper surface portion is p⁺⁺.

Here, the first semiconductor layer 20a and the second semiconductor layer 20b are separately formed, however, they may be formed continuously. An integral formation of the first semiconductor layer 20a and the second semiconductor layer 20b is performed by adjusting a supply amount of impurities. In the integral semiconductor layer 20A, it is considered that the first semiconductor layer 20a and the second semiconductor layer 20b are divided at an inflection point, in which the increase and decrease in the dopant concentration are changed.

In the semiconductor layer 20A formed in this way, the dopant concentration in the middle portion in the thickness direction is lowest, and the dopant concentration is increased as it approaches the upper surface side and the lower surface side (first substrate 10 side). That is, the semiconductor layer 20A includes the first region 20x on the first substrate 10 side in the thickness direction, and includes a second region 20y on the main surface side opposite to the first substrate 10. The second region 20y is formed so that the dopant concentration is decreased from the main surface of the semiconductor layer which is on the side opposite to the first substrate 10, toward the first substrate 10 side of the semiconductor layer in the thickness direction of the semiconductor layer. Moreover, in this example, the dopant concentration in the main surface on the side opposite to the first substrate 10 of the second region 20y is higher than the threshold. In addition, an intermediate region 20z in which the dopant concentration is less than or equal to the threshold is provided between the first region 20x and the second region 20y.

In the above-described step, in the first semiconductor layer 20a and the second semiconductor layer 20b, the epitaxial growth may not be performed until the diffusion concentration of the dopant is saturated.

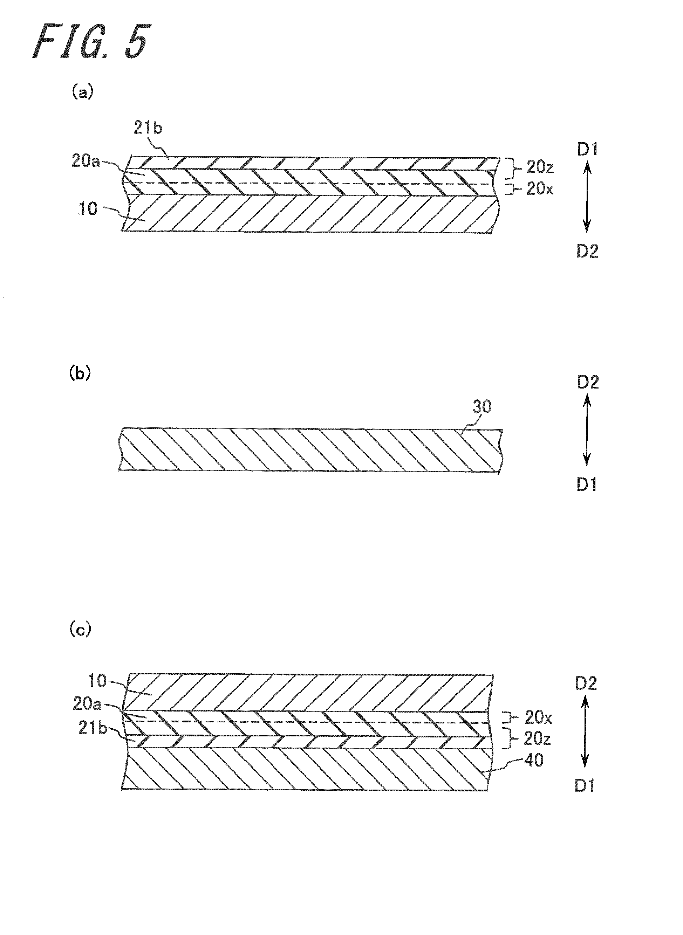

Subsequently, the second semiconductor layer 20b of the semiconductor layer 20A is etched from the arrow D1 direction side, and as shown in Fig. 5(a), the thickness of the second semiconductor layer 20b is decreased. The etching can be performed by adopting a selective etchant in which the etching speed is greatly changed due to differences in the dopant concentration. If the dopant concentration exceeds or is less than a predetermined value, the selective etchant is adjusted so that the etching speed is significantly decreased. For example, examples of the selective etchant include a mixture of hydrofluoric acid, nitric acid and acetic acid, and a mixture of hydrofluoric acid, nitric acid and water. In the present embodiment, similar to the etchant in the first embodiment, the mixture of hydrofluoric acid, nitric acid, and acetic acid is adopted as the etchant. In the second semiconductor layer 20b, the second region 20y is etched. Here, the second semiconductor layer, in which the thickness is decreased by etching, becomes a second thin layer 21b.

Subsequently, as shown in Fig. 5(b), similar to Fig. 1(c), the second substrate 30 of insulation is prepared.

Subsequently, as shown in Fig. 5(c), the second substrate 30 and the upper surface in the first direction side of the second thin layer 21b are bonded to each other. As for the bonding method, it is possible to use the method similar to the bonding between the second substrate 30 and the semiconductor layer 20 in the first embodiment.

Through the steps up to here, an intermediate product, which includes the semiconductor layer 20A between the first substrate 10 and the second substrate 30, is generated.

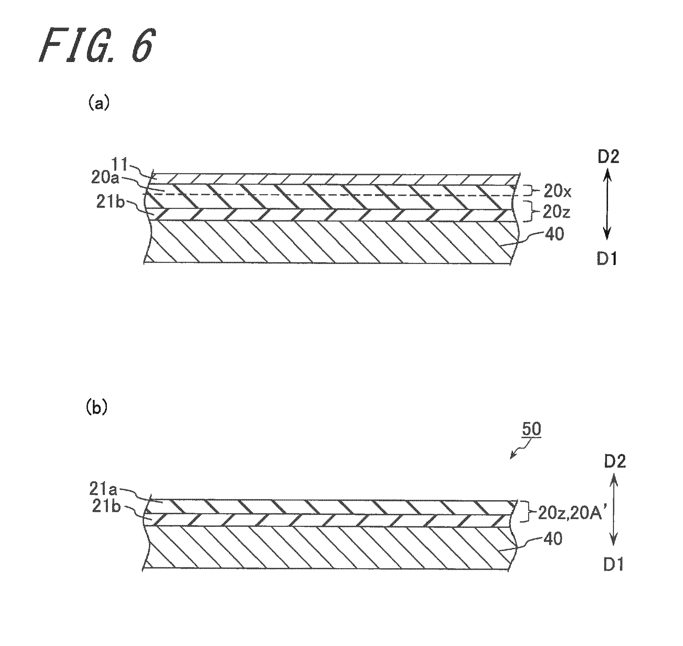

Subsequently, as shown in Fig. 6(a), the thickness of the first substrate 10 is decreased by processing the intermediate product from the arrow D2 direction side. As for the processing method of decreasing the thickness, the method similar to the method described using Fig. 2(b) in the first embodiment can be used. Here, the first substrate in which the thickness is decreased becomes the first thin substrate 11.

In addition, as shown in Fig. 6(b), the thickness of the first semiconductor layer 20a of the semiconductor layer 20A is decreased by performing etching using an etchant after the grinding. This etching can be performed by adopting a selective etchant in which the etching speed is greatly changed due to difference of the dopant concentration. Examples of the selective etchant include etchants similar to those described above. In the first semiconductor layer 20a, the first region 20x is etched. Here, the first semiconductor layer in which the thickness is thinned by etching becomes a first thin layer 21a. In addition, when the first substrate 10 or the first thin substrate 11 remains, the remaining first substrate 10 or the first thin substrate 11 is also etched.

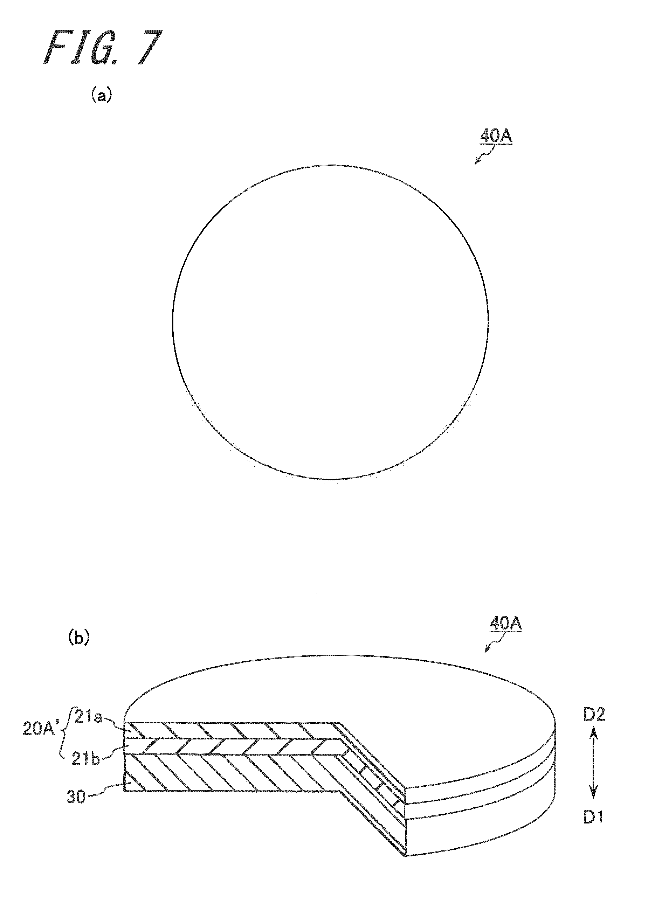

Through the steps up to here, as shown in Fig. 7, a composite substrate 40A can be manufactured which has a semiconductor layer 20A' in which one main surface is bonded to the substrate 30 on the upper surface of the arrow D2 direction side of the insulating substrate 30. The dopant concentration of the semiconductor layer 20A' is gradually increased from the middle portion in the thickness direction of the semiconductor layer 20A' toward one main surface or the other main surface of the semiconductor layer 20A'. Here, the substrate 30 indicates the second substrate 30 through the above-described manufacturing method. Similarly, the semiconductor layer 20A' indicates the layer in which the second thin layer 21b and the first thin layer 21a through the above-described manufacturing method are laminated. That is, the semiconductor layer 20A' is configured by the intermediate region 20z of the semiconductor layer 20A. In other words, in the composite substrate 40A, the functional layer which includes the second thin layer 21b and the first thin layer 21a is bonded to the upper surface of the arrow D2 direction side of the second substrate 30. When the second thin layer 21b and the first thin layer 21a are considered as a single functional layer, in the dopant of the semiconductor layer, the middle portion in arrow directions D1 and D2 is smaller than both end sides. Conversely, the dopant of the functional layer is gradually increased from the middle portion in the thickness direction of the functional layer toward both end sides in the thickness direction of the functional layer. In addition, when the dopant concentration is considered as magnitude of an electric resistance, the electric resistance of the functional layer is gradually decreased from the intermediate portion toward both end sides in the thickness direction of the functional layer.

In the above-described manufacturing method, gradient of the dopant concentration is formed on the surface of the side which is to be bonded to the second substrate 30 before being bonded to the second substrate 30. In this way, since the gradient is formed before the bonding, compared to a case where the gradient is formed after the bonding, unevenness of the thickness of the functional layer which is formed on the upper surface of the second substrate 30 can be decreased. If the gradient is formed after the bonding, since the processing is performed from the lower surface of the first substrate 10, the functional layer is subjected to influence of unevenness of the thickness of the first substrate 10 or to influence of warping of the second substrate 30. A case where the functional layer in which the thickness is smaller than at least one of an unevenness amount of the thickness of the first substrate 10 and a warping amount of the second substrate 30 is formed is particularly effective.

As the above-described manufacturing method, since the dopant concentration is designed in the thickness direction of the semiconductor layer 20A, the dopant concentration of the portion which is left as the functional layer can be freely designed. For example, even when the dopant concentration of not less than the threshold is required in the functional layer, a functional layer having a desired dopant concentration can be accurately manufactured in a desired thickness.

In the above-described example, before the second semiconductor layer 20b is bonded to the second substrate 30, the etching step which removes the second region of the second semiconductor layer 20b is provided. However, when the layer having a low resistance is left as the functional layer, the etching step may be omitted.

In the above-described example, the second region 20y is formed so as to have the dopant concentration of not less than the threshold in the main surface on the side opposite to the first substrate 10. However, the dopant concentration of the second region may be less than or equal to the threshold.

### (Modified Examples of First Embodiment and Second Embodiment)

In the example of each embodiment described above, when the semiconductor layers 20 and 20A and the second substrate 30 are bonded to each other, the main surfaces of the semiconductor layers 20 and 20A on the side opposite to the first substrate 10 may be in an amorphous state.

Moreover, it is preferable that the semiconductor layers 20 and 20A are formed so as to have the thickness of not less than an undulation level of the second substrate 30. For example, when a sapphire substrate is used as the second substrate 30, since the sapphire substrate has an undulation level of an approximately 10 µm, it is preferable that the thicknesses of the semiconductor layers 20 and 20A are equal to or more than 10 µm. The semiconductor layers are formed in this way, and thus, the functional layer 21 having a desired thickness can be formed without receiving adverse effects of an undulation level of the second substrate 30.

### Reference Signs List

10: First substrate
11: First thin substrate
20: Semiconductor layer
20x: First region
20y: Second region
20z: Intermediate region
21: Functional layer
30: Second substrate
40: Composite substrate

## Claims

1. A method of manufacturing a composite substrate, comprising:
preparing a first substrate which is formed of a first silicon having a dopant;
forming a semiconductor layer formed by an epitaxial growth a second silicon on a main surface of the first substrate;
bonding the semiconductor layer and a second substrate of insulating; and
after the bonding, selectively etching the semiconductor layer from a side of the first substrate up to a middle portion in a thickness direction of the semiconductor layer by using an etchant, wherein
the etchant has an etching rate with respect to silicon which decreases by a not less than an certain value in a dopant concentration of a threshold lower than a dopant concentration of the first substrate, and
in the forming the semiconductor layer, the semiconductor layer is formed so as to comprise a first region in a thickness direction of the first substrate, the first region being in contact with the first substrate and in which a dopant concentration thereof decreases to the threshold as a distance from the first substrate increasing.

2. The method of manufacturing a composite substrate according to claim 1, wherein,
in the forming the semiconductor layer, the semiconductor layer is formed so that the dopant concentration decreases as the distance from the first substrate increasing.

3. The method of manufacturing a composite substrate according to claim 2, wherein,
in the forming the semiconductor layer, the epitaxial growth of the semiconductor layer is performed by diffusing the dopant from the first substrate, the diffusing being finished before the dopant concentration is saturated.

4. The method of manufacturing a composite substrate according to claim 1, wherein,
in the forming the semiconductor layer, the semiconductor layer is formed so as to comprise a second region in the thickness direction of the semiconductor layer, the second region has a dopant concentration being gradually decreased from a main surface on a side opposite to the first substrate toward a side of the first substrate.

5. The method of manufacturing a composite substrate according to claim 4, wherein,
in the forming the semiconductor layer, the semiconductor layer is formed so that the dopant concentration of the main surface on the side opposite to the first substrate in the second region is higher than the threshold.

6. The method of manufacturing a composite substrate according to claim 4 or 5, wherein,
in the forming the semiconductor layer, the semiconductor layer is formed so as to comprise an intermediate region between the first region and the second region, the intermediate region having a dopant concentration which is less than or equal to the threshold.

7. The method of manufacturing a composite substrate according to any one of claims 4 to 6, further comprising:
removing a part of the second region of the semiconductor layer in a thickness direction by etching, the removing being carried out between of the forming the semiconductor layer and the bonding the semiconductor layer and the second substrate.

8. The method of manufacturing a composite substrate according to any one of claims 1 to 7, wherein,
in the forming the semiconductor layer, the semiconductor layer is formed so as to have a thickness of not less than an undulation level of the second substrate.

9. The method of manufacturing a composite substrate according to any one of claims 1 to 8, wherein,
in the bonding the semiconductor layer and the second substrate, bonding the semiconductor layer and the second substrate is performed by activating main surfaces of the both which are bonded to each other and then bringing the main surfaces of the both into contact with each other at a room temperature.

10. The method of manufacturing a composite substrate according to any one of claims 1 to 9, wherein,
in the bonding the semiconductor layer and the second substrate, the main surface of the semiconductor layer on the side opposite to the first substrate is made into an amorphous state.

11. A composite substrate, comprising:
an insulating substrate; and
a semiconductor layer of which one main surface is bonded to an upper surface of the insulating substrate,
wherein a dopant concentration of the semiconductor layer decreases from the other main surface of the semiconductor layer toward a side of the insulating substrate.

12. A composite substrate, comprising:
an insulating substrate; and
a semiconductor layer of which one main surface is bonded to an upper surface of the insulating substrate,
wherein a dopant concentration of the semiconductor layer increases from a middle portion in a thickness direction of the semiconductor layer toward the other main surface of the semiconductor layer and a side of the semiconductor layer, respectively.
